# EUROPEAN PATENT APPLICATION

(11) **EP 4 628 355 A1**
(43) Date of publication of application: **08.10.2025**
(21) Application number: 24168819.1
(22) Date of filing: 05.04.2024
(51) Int. Cl.: B60L 58/13, B60L 58/14, B60L 58/16, B60W 60/00, G01R 31/367, G01R 31/387, H02J 7/00

(54) **COMPUTER SYSTEM FOR STATE OF CHARGE MASKING**

(71) Applicant: VOLVO TRUCK CORPORATION, 405 08 Göteborg (SE)
(72) Inventor: Marcus, VIKÉN, 411 01 GÖTEBORG (SE); Lucas, BILLSTEIN, 422 41 HISINGS BACKA (SE); BORGELSSON MAANINKA, Adam, 423 38 TORSLANDA (SE)
(74) Representative: Ström & Gulliksson AB

(57) **Abstract**

A computer system (**100**) is presented. The computer system (**100**) comprises processing circuitry (**110**) configured to obtain measured state of charge, SOC, data (**215**) of an energy source (**14**) of a vehicle and determine that a measured SOC decrease rate is above an expected SOC decrease rate by a predetermined SOC decrease rate threshold. The processing circuitry (**110**) is further configured to determine an SOC difference based on the measured SOC data and the expected SOC decrease rate, and determine an SOC correction based on the SOC difference. The processing circuitry (**110**) is further configured to reduce an SOC buffer of the energy source (**14**) by the SOC correction, and provide filtered SOC data (**265**) of the energy source (**14**) by increasing the measured SOC data (**215**) by the SOC correction.

## Description

### TECHNICAL FIELD

The disclosure relates generally to management of energy in an electric vehicle. In particular aspects, the disclosure relates to masking of a state of charge of energy sources of an electrified vehicle. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

Accurately estimating a state of charge (SOC) of energy sources, such as batteries, in an electric vehicle (EV) is important. Failure to reliably estimate a current SOC of a battery may cause the battery to deplete during operation or cause the battery to be charged even though it is not needed. Deep discharges may, depending on battery technology, degrade a capacity of the battery and potentially reduce a lifetime of the battery.

However, accurate estimation of SOC of a battery is challenging; a relationship between a battery voltage, a current, and a SOC is generally nonlinear and may be affected by various factors such as temperature, aging, and load conditions of the battery.

### SUMMARY

According to a first aspect of the disclosure, a computer system is presented. The computer system comprises processing circuitry configured to: obtain measured state of charge, SOC, data of an energy source of a vehicle, determine that a measured SOC decrease rate is above an expected SOC decrease rate by a predetermined SOC decrease rate threshold; determine an SOC difference based on the measured SOC data and the expected SOC decrease rate; determine an SOC correction based on the SOC difference; reduce an SOC buffer of the energy source by the SOC correction; and provide filtered SOC data of the energy source by increasing the measured SOC data by the SOC correction. The first aspect of the disclosure may seek to reduce a risk that a higher SOC than actually available is provided. Technical benefits may include reduced anxiety of an operator of the vehicle, reduction of sudden shifts in reported SOC, and/or reduced risk of the vehicle running out of energy during operation

Optionally in some examples, including in at least one preferred example, the processing circuitry is further configured to: determine the expected SOC decrease rate based on energy drained from the energy source. A technical benefit may include accurate detections of e.g. calibration events and similar occurring at the energy source.

Optionally in some examples, including in at least one preferred example, the processing circuitry is further configured to: the processing circuitry is further configured to: determine that the measured SOC data is below a predetermined maximum SOC threshold and above an intermediate SOC threshold; increase the SOC buffer by a SOC increase value; and provide filtered SOC data of the energy source by decreasing the measured SOC data by the SOC increase value. A technical benefit may include controllably and smoothly and without adversely affecting propulsion of the vehicle, providing a buffer for the SOC.

Optionally in some examples, including in at least one preferred example, the processing circuitry is further configured to: determine that the measured SOC data is below the intermediate SOC threshold and above a minimum SOC threshold; decrease the SOC buffer by a SOC decrease value; and provide filtered SOC data of the energy source by increasing the measured SOC data by the SOC decrease value. A technical benefit may include controllably and smoothly and without adversely affecting propulsion of the vehicle, reducing a buffer for the SOC.

Optionally in some examples, including in at least one preferred example, the processing circuitry is further configured to: determine the SOC decrease value such that the SOC buffer is substantially zero when the measured SOC data is at the minimum SOC threshold. A technical benefit may include providing the SOC buffer without affecting a range of the vehicle.

Optionally in some examples, including in at least one preferred example, the processing circuitry is further configured to: determine that the SOC difference is greater than the SOC buffer; reduce a minimum SOC threshold by the by the SOC correction; and prevent propulsion of the vehicle responsive to the measured SOC data being below the minimum SOC threshold. A technical benefit may include masking shifts in the measured SOC even when the SOC buffer is substantially empty.

Optionally in some examples, including in at least one preferred example, the SOC buffer is equal to a minimum SOC threshold, and the processing circuitry is further configured to: prevent propulsion of the vehicle responsive to the measured SOC data being below the minimum SOC threshold. A technical benefit may include controllably and smoothly and without adversely affecting propulsion of the vehicle, reducing a buffer for the SOC.

Optionally in some examples, including in at least one preferred example, the processing circuitry is further configured to: determine that a SOC decrease rate is above the expected SOC decrease rate by comparing measured SOC data to previous measured SOC data. A technical benefit may include accurate detections of e.g. calibration events and similar occurring at the energy source.

Optionally in some examples, including in at least one preferred example, the processing circuitry is further configured to: determine the expected SOC decrease rate based on energy drained from the energy source; determine that the measured SOC data is below a predetermined maximum SOC threshold and above an intermediate SOC threshold, increase the SOC buffer by a SOC increase value, and provide filtered SOC data of the energy source by decreasing the measured SOC data by the SOC increase value; determine that the measured SOC data is below the intermediate SOC threshold and above a minimum SOC threshold, decrease the SOC buffer by a SOC decrease value, and provide filtered SOC data of the energy source by increasing the measured SOC data by the SOC decrease value; determine the SOC decrease value such that the SOC buffer is substantially zero when the measured SOC data is at the minimum SOC threshold; determine that the SOC difference is greater than the SOC buffer, reduce a minimum SOC threshold by the by the SOC correction, and prevent propulsion of the vehicle responsive to the measured SOC data being below the minimum SOC threshold; determine that a SOC decrease rate is above the expected SOC decrease rate by comparing measured SOC data to previous measured SOC data; and determine that a SOC decrease rate is above the expected SOC decrease rate by obtaining a SOC data calibration event indicator from the energy source. A technical benefit may include, in addition to the benefits listed above, that even more accurate detections of e.g. calibration events and similar occurring at the energy source is provided.

According to a second aspect of the disclosure, a battery pack is presented. The battery pack comprises one or more battery cells and the computer system of the first aspect configured to obtain measured SOC data of at least one of the one or more battery cells. The second aspect of the disclosure may seek to reduce a risk that a higher SOC than actually available is provided. Technical benefits may include reduced anxiety of an operator of the vehicle, reduction of sudden shifts in reported SOC and reduced risk of the vehicle running out of energy during operation

According to a third aspect of the disclosure, an energy management system is presented. The energy management system comprises one or more battery packs and the computer system of the first aspect configured to obtain measured SOC data of at least one of the one or more battery packs. The third aspect of the disclosure may seek to reduce a risk that a higher SOC than actually available is provided. Technical benefits may include reduced anxiety of an operator of the vehicle, reduction of sudden shifts in reported SOC and reduced risk of the vehicle running out of energy during operation.

According to a fourth aspect of the disclosure, a vehicle is presented. The vehicle comprises one or more energy sources and the computer system of any one of claims 1 to 9 configured to obtain measured SOC data of at least one of the one or more energy sources. The fourth aspect of the disclosure may seek to reduce a risk that a higher SOC than actually available is provided. Technical benefits may include reduced anxiety of an operator of the vehicle, reduction of sudden shifts in reported SOC and reduced risk of the vehicle running out of energy during operation.

According to a fifth aspect of the disclosure, a computer implemented method is presented. The computer implemented method comprises obtaining, by processing circuitry of a computer system, measured state of charge, SOC, data of an energy source of a vehicle, determining, by processing circuitry of the computer system, that a measured SOC decrease rate is above an expected SOC decrease rate by a predetermined SOC decrease rate threshold; determining, by processing circuitry of the computer system, an SOC difference based on the measured SOC data and the expected SOC decrease rate; determining, by processing circuitry of the computer system, an SOC correction based on the SOC difference; reducing, by processing circuitry of the computer system, an SOC buffer of the energy source by the SOC correction; and providing, by processing circuitry of the computer system, filtered SOC data of the energy source by increasing the measured SOC data by the SOC correction. The fifth aspect of the disclosure may seek to reduce a risk that a higher SOC than actually available is provided. Technical benefits may include reduced anxiety of an operator of the vehicle, reduction of sudden shifts in reported SOC and reduced risk of the vehicle running out of energy during operation.

According to a sixth aspect of the disclosure, a computer program product is presented. The computer program product comprises program code for performing, when executed by processing circuitry, the computer implemented method of the fifth aspect. The sixth aspect of the disclosure may seek to reduce a risk that a higher SOC than actually available is provided. Technical benefits may include reduced anxiety of an operator of the vehicle, reduction of sudden shifts in reported SOC and reduced risk of the vehicle running out of energy during operation.

According to a seventh aspect of the disclosure, a non-transitory computer-readable storage medium is presented. The non-transitory computer-readable storage medium comprises instructions, which when executed by processing circuitry, cause the processing circuitry to perform the computer implemented method of the fifth aspect. The seventh aspect of the disclosure may seek to reduce a risk that a higher SOC than actually available is provided. Technical benefits may include reduced anxiety of an operator of the vehicle, reduction of sudden shifts in reported SOC and reduced risk of the vehicle running out of energy during operation.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.
**FIG. 1** is a side view of an exemplary vehicle according to an example.
**FIG. 2** is a schematic view of an exemplary SOC masker according to an example.
**FIG. 3** are exemplary time-series plots of SOCs and SOC buffer according to an example.
**FIG. 4** are exemplary time-series plots of SOCs and SOC buffer according to an example.
**FIG. 5** are exemplary time-series plots of SOCs and SOC buffer according to an example.
**FIG. 6A** is an exemplary block diagram of a computer system according to an example.
**FIG. 6B** is an exemplary block diagram of an energy source according to an example.
**FIG. 6C** is an exemplary block diagram of a battery pack according to an example.
**FIG. 6D** is an exemplary block diagram of an energy management system according to an example.
**FIG. 7** is a schematic view of a method according to an example.
**FIG. 8** is a block diagram of a computer program product according to an example.
**FIG. 9** is a schematic view of an exemplary SOC masker according to an example.
**FIG. 10** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

An operator of an electric vehicle (EV) will generally consult a state of charge (SOC) indicator at an instrument cluster of the EV to learn how much energy is left in an energy source of the EV. Based on the indicated SOC, the operator may try to estimate a remaining distance the EV may travel before the energy source needs to be charged. As indicated above, estimating the SOC is challenging. Further, inaccuracies in the estimated SOC may accumulate over time when charging/discharging the energy source of the EV.

Generally, processes are in place that detect inaccuracies in the estimation of SOC and attempt to correct these inaccuracies once detected. Generally, such corrections will cause the SOC to drop/jump comparably fast, sometimes several percentage points (units of percent). If a correction downwards, i.e. it is determined that the estimated SOC is too high, would happen at a low SOC region, this may cause significant anxiety to the driver. If a correction upwards, i.e. it is determined that the estimated SOC is too low, would happen at a low SOC region, the driver may become overconfident in estimating a remaining route at specific SOC levels. Sudden shifts in the reported SOC may cause operators of EVs to lose faith in the estimated SOC and lead to unnecessary charging time (decreased utilization) increasing cost of ownership of the EV. The latter is of particular importance if the EV is a commercial vehicle such as, but not limited to, trucks or other transportation vehicles.

The present disclosure provides a computer system and a method that will mask sudden SOC drops increasing a user experience for the operator. The teachings herein will obscure an SOC reported from an energy source and present an SOC that is slightly lower than the SOC reported from the energy source. The difference between the SOC reported from the energy source and the presented SOC is referred to as an SOC buffer. If a sudden drop in SOC is determined, the unit of percent in SOC that was lost in the drop may be deducted from the SOC buffer and no sudden shift is required in the presented SOC.

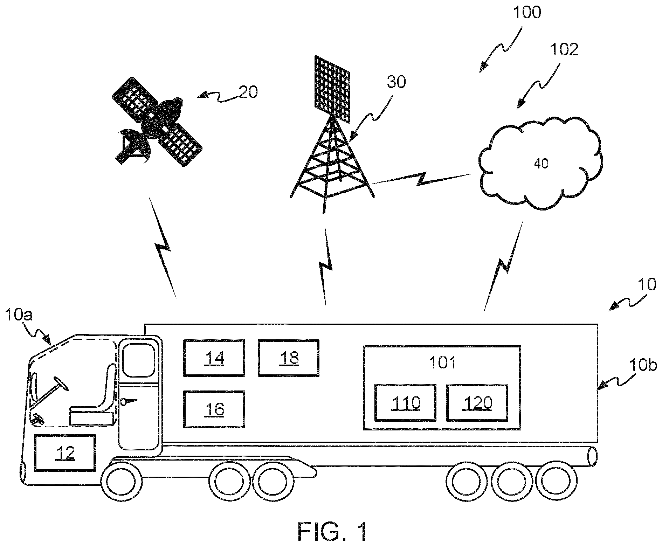

**FIG. 1** is an exemplary schematic side view of a heavy-duty vehicle **10** (hereinafter referred to as vehicle **10**). The vehicle **10** comprises a tractor unit **10a** which is arranged to tow a trailer unit **10b.** In other examples, other vehicles may be employed, e.g., trucks, buses, and construction equipment. The vehicle **10** comprises all vehicle units and associated functionality to operate as expected, such as a powertrain, chassis, and various control systems. The vehicle **10** comprises one or more propulsion sources **12.** The propulsion source **12** may be any suitable propulsion source **12** exemplified by, but not limited to one or more electrical motors or, one or more electrical motors in combination with one or more combustion engines such as a diesel, gas or gasoline powered engines. The vehicle **10** further comprises an energy source **14** suitable for providing energy for the propulsion source **12.** That is to say, if the propulsion source **12** is an electrical motor, a suitable energy source **14** would be a battery or a fuel cell. The vehicle **10** further comprises sensor circuitry **16** arranged to detect, measure, sense or otherwise obtain data relevant for operation of the vehicle **10.** The sensor circuit **16** may comprise one or more of a current sensor, a voltage sensor, a coulomb counter, an accelerometer, a gyroscope, a wheel speed sensor, an ABS sensor, a throttle position sensor, a fuel level sensor, a temperature sensor, a pressure sensor, a rain sensor, a light sensor, proximity sensor, a lane departure warning sensor, a blind spot detection sensor, a TPMS sensor etc. Operational data relevant for operation of the vehicle **10** may include, but is not limited to, one or more of a speed of the vehicle **10**, a weight of the vehicle **10**, an inclination of the vehicle **10**, a status of the energy source **14** of the vehicle **10** (SOC, fuel level etc.), a current speed limit of a current road travelled by the vehicle **10**, etc. The vehicle **10** may further comprise communications circuitry **18** configured to receive and/or send communication. The communications circuitry **18** may be configured to enable the vehicle **10** to communicate with one or more external devices or systems such as a cloud server **40.** The communication with the external devices or systems may be directly or via a communications interface such as a cellular communications interface **30**, such as a radio base station. The cloud server **40** may be any suitable cloud server exemplified by, but not limited to, Amazon Web Services (AWS), Microsoft Azure, Google Cloud Platform (GCP), IBM Cloud, Oracle Cloud Infrastructure (OCI), DigitalOcean, Vultr, Linode, Alibaba Cloud, Rackspace etc. The communications interface may be a wireless communications interface exemplified by, but not limited to, Wi-Fi, Bluetooth, Zigbee, Z-Wave, LoRa, Sigfox, 2G (GSM, CDMA), 3G (UMTS, CDMA2000), 4G (LTE), 5G (NR) etc. The communication circuitry **18** may, additionally or alternatively, be configured to enable the vehicle **10** to be operatively connected to a Global Navigation Satellite System (GNSS) **20** exemplified by, but not limited to, global positioning system (GPS), Globalnaya Navigatsionnaya Sputnikovaya Sistema (GLONASS), Galileo, BeiDou Navigation Satellite System, Navigation with Indian Constellation (NavIC) etc. The vehicle **10** may be configured to utilize data obtain from the GNSS **20** to determine a geographical location of the vehicle **10.**

The vehicle **10** thus forms part of, or implements, a computer system **100** comprising processing circuitry **102** configured to mask sudden SOC drops as will be described in the following. To achieve this, the vehicle **10** comprises a computing device **101.** The computing device **101** may be operatively connected to the communications circuitry **18**, the sensor circuitry **16**, the energy source **14**, and/or the propulsion source **12** of the vehicle **10.** The computing device **101** comprises a processor **110.** The computing device **101** may comprise a storage device **120**, advantageously a non-volatile storage device such as a hard disk drives (HDDs), solid-state drives (SSDs) etc. In some examples, the storage device **120** is not comprised in the computing device **101** but rather operatively connected to the computing device **101.**

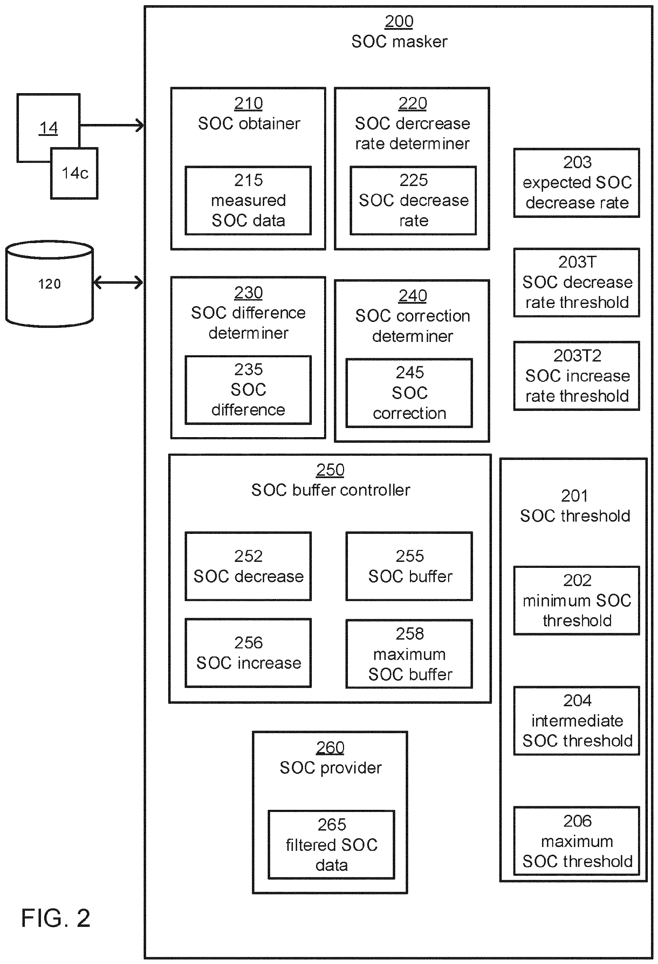

With reference to **FIG. 2**, an architectural overview of an exemplary SOC masker **200** will be presented. The computer system **100**, or rather the processor **110** of the computing device **101**, may configured to perform, or cause performance of, any or all features of the SOC masker **200.** The SOC masker **200** comprises an SOC obtainer **210**, an SOC decrease rate determiner **220**, an SOC difference determiner **230**, an SOC correction determiner **240**, an SOC buffer controller **250**, and an SOC provider **260**, these will be described in further detail in the following. The SOC masker **200** is generally associated with a specific energy source **14**, which may be a battery pack, a group of battery packs, a battery cell, etc. In some examples, the energy source **14** is an energy source of a vehicle **10.** The SOC masker **200** provides filtered SOC data **265** that reduces a risk of an operator of a vehicle **10** being exposed to excessive and/or sudden jumps or shift in a SOC indication of the vehicle **10.**

The SOC obtainer **210** is configured to obtain, measure or otherwise acquire measured SOC data **215** of an energy source **14** of a vehicle **10.** The actual measurement of the measured SOC data **215** may be provided by circuitry of the energy source **14**, the vehicle **10** and/or the SOC obtainer **210.** The measured SOC data **215** describes at least a SOC of the energy source **14** but may provide data describing other parameters of the energy source **14** such as, but not limited to, a voltage of the energy source **14,** a current from (discharge current) or to (charge current) the energy source **14**, a temperature of the energy source **14**, a state of health SoH of the energy source, etc.

The SOC of the energy source **14** may be measured in any suitable way for instance by voltage measurement of the energy source **14.** The voltage of an energy source **14** generally relate to an SOC of the energy source **14.** However, the relationship between voltage and SOC generally requires measurement of an open cell voltage (OCV) and even then, the relationship may not be linear and may vary depending on factors like temperature and battery chemistry.

Impedance spectroscopy is an alternative method of estimating the SOC of an energy source **14.** By analyzing an impedance of the energy source **14** at different frequencies, an SOC of the energy source **14** may be inferred. Impedance spectroscopy involves applying a comparably small AC signal to the energy source **14** and measuring the response. A changes in impedance may indicate changes in SOC. Impedance spectroscopy is generally considered complex and requires specialized hardware to provide the AC signal and obtain the response.

Another way of estimating the SOC of the energy source **14** is by coulomb counting. Coulomb counting involves integrating a current flowing into or out of the energy source **14** over time. By tracking a total charge transferred, the SOC may be estimated.

Generally, estimations of SOC are associated with some uncertainty and may be subject to drift due to temperature changes, inaccuracies in current measurements, control loop wind-up, noise, etc. Due to this, two or more SOC estimation techniques are generally paired when estimating SOC to compensate for SOC drift. Techniques like Kalman filters or extended Kalman filters may be used to continuously estimate the SOC while simultaneously detecting drift. If a drift is detected, or for other purposes, the SOC estimation may be calibrated to correct drifts over time. This generally involves comparing the estimated SOC with a reference SOC obtained through more accurate means, such as full charge-discharge cycles, and adjusting the estimation algorithm accordingly. The calibration of the estimated SOC may result in a shift of the measured SOC **215.** These shifts in the measured SOC **215** may, as previously explained, cause anxiety of an operator of the vehicle **10.**

To this end, the SOC decrease rate determiner **220** is configured to determine an SOC decrease rate **225.** The SOC decrease rate **225** may be determined by comparing current measured SOC data **215** to previously measured SOC data **215**, specifically comparing a current SOC of the energy source **14** to a previous SOC of the energy source **14.** The SOC decrease rate **225** may be determined for a predetermined or configurable time period. The time period may not be a time per say, but may be defined as number of sample periods for the measured SOC data **215.** In some examples, the measured SOC data **215** may be compared to a sliding average of a number of previously measured SOC data **215.** Also, the measured SOC data **215** may be formed by averaging over a number of samples of measured SOC data **215.** Averaging the measured SOC data **215** reduces noise in the measured data.

The SOC decrease rate determiner **220** may be configured to compare the SOC decrease rate **225** to an expected SOC decrease rate **203** of the SOC masker **200.** The expected SOC decrease rate **203** describes an expected decrease rate of the SOC of the energy source **14.** The expected decrease rate **203** may be a predetermined rate fixed rate independent of loading conditions (input current, output current etc.) and/or operating conditions (temperature, humidity etc.) for the energy source **14.** In some examples, the expected decrease rate **203** is a variable decrease rate that may vary depending on current loading conditions and/or current operating conditions. In some examples, the SOC masker **200** is configured to determine the expected decrease rate **203** based on a current energy drained from the energy source **14.** In some examples, the energy drained from the energy source **14** is obtained by (based on) coulomb counting of a current drained from the energy source **14.**

In some examples, the SOC decrease rate determiner **220** may be configured to obtain a SOC data calibration event indicator **14c** form the energy source **14.** The SOC data calibration event indicator **14c** may be configured to indicate that a calibration of the energy source **14** has occurred, or is about to occur. The SOC decrease rate determiner **220** may be configured to selectively determine the SOC decrease rate **225** responsive to obtaining the SOC data calibration event indicator **14c.** In some examples, the SOC data calibration event indicator **14c** may comprise the SOC decrease rate **225,** and/or any other data indicating an amount of change in SOC of the energy source **14** the recalibration caused. The SOC decrease rate determiner **220** may be configured to determine the SOC decrease rate **225** based on the SOC data calibration event indicator **14c.**

The SOC decrease rate determiner **220** may be configured to compare the SOC decrease rate **225** to the expected SOC decrease rate **203** to determine if the SOC decrease rate **225** is above the expected SOC decrease rate **203.** In some examples, the SOC decrease rate determiner **220** may be configured to compare the SOC decrease rate **225** to the expected SOC decrease rate **203** to determine if the SOC decrease rate **225** is above the expected SOC decrease rate **203** by a predetermined SOC decrease rate threshold **203T.** The SOC decrease rate threshold **203T** reduces a risk that temporary noise, incorrect measurements or other factors cause the SOC decrease rate determiner **220** to incorrectly determine that the SOC decrease rate **225** is above the expected SOC decrease rate **203.**

Responsive to the SOC decrease rate determiner **220** determining that the SOC decrease rate **225** is above the expected SOC decrease rate **203** (strictly above or by the SOC decrease rate threshold **203T**), the SOC difference determiner **230** may be configured to determine an SOC difference **235**. The SOC difference determiner **230** may be configured to determine the SOC difference **235** based on the measured SOC data **215** and the expected SOC decrease rate **203.** In some examples, the SOC difference determiner **230**, may be configured to determine the SOC difference **235** by decreasing a previous SOC measurement based on the expected SOC rate **203** and compare the decreased previous SOC measurement to the measured SOC data **215.**

In other words, the SOC decrease rate determiner **220** may be described as determining if the SOC of the energy source **14** has decreased more than expected. The SOC difference **235** may be described as how much more than expected, the SOC of the energy source **14** has decreased. That is to say, based on the SOC decrease rate determiner **220** and the SOC difference determined **230**, the SOC masker **200** may determine that, and how much, the measured SOC data **215** differs from expected SOC data.

Responsive to the SOC decrease rate determiner **220** determining that the SOC decrease rate **225** is above the expected SOC decrease rate **203** (strictly above or by the SOC decrease rate threshold **203T**), the SOC correction determiner **240** may be configured to determine an SOC correction **245.** The SOC correction **245** describes how much the measured SOC data **215** is to be increased prior to reporting the filtered SOC data **265.** The SOC correction determiner **240** may be configured to determine the SOC correction **245** based on the SOC difference **235.** In some examples, the SOC correction **245** is equal to the SOC difference **235.** In some examples, the SOC correction **245** is the SOC difference **235** multiplied by a scaling factor. The scaling factor is, in some examples, lower than 1 but greater than 0. In other words, the scaling factor may be provided such that not the entire SOC difference **235** is corrected by the SOC correction **245.** This will present a slight shift also in the filtered SOC data **265,** but, as will be seen in the following, a maximum SOC buffer **258** may be decreased.

Consequently, if the filtered SOC data **265** is the measured SOC data **215** increased by the SOC difference **235,** or the SOC difference multiplied by the scaling factor, the filtered SOC data **265,** i.e. the SOC data provided for presentation to an operator of the vehicle **10** of for processing by other devices, services of circuitry of the vehicle **10,** exhibits a smaller, or no, jump in SOC compared to a previous SOC of the energy source **14.** Among other things, this reduces a risk that an operator gets agitated by sudden shift in the reported SOC of the energy source **14,** or even is forced to stop driving due to the SOC being below a minimum SOC threshold **202.**

In order to not simply obscure the true SOC of the energy source and provide a false sense of security for the operator of the vehicle **10,** a SOC buffer **255** is provided. The SOC buffer **255** is controlled by the SOC buffer controller **250.** The SOC buffer **255** may be described as a temporary and virtual SOC storage that allows shifts in the measured SOC data **215** to be masked. Consequently, if the filtered SOC data **265** is increased by the SOC correction **245,** the SOC buffer controller **250** will decrease the SOC buffer **255** by the SOC correction **245.** In other words, an increase of the filtered SOC data **265** compared to the measured SOC data **215** will lead to a corresponding decrease of the SOC buffer **255.**

The SOC buffer controller **250** may, in some examples, further be configured to increase and/or decrease the SOC buffer **255** independently of the SOC decrease rate determiner **220** determining that the SOC decrease rate **225** is above the expected SOC decrease rate **203** (strictly above or by the SOC decrease rate threshold **203T**). In some examples, the SOC buffer controller **250** may be configured to increase the SOC buffer **255** selectively under certain conditions, and to decrease the SOC buffer **255** selectively under other conditions. Since the SOC buffer **255** is a virtual buffer and not a true energy storage, SOC buffer controller **250** may be configured to control the SOC buffer **255** to approach zero (i.e. empty) when the measured SOC data **215** is close to the minimum SOC threshold **202,** i.e. a minimum usable SOC of the vehicle **10.** A sudden shift in SOC will cause less anxiety if the energy source **14** is close to full, to this end, in some examples, the SOC buffer controller **250** may be configured to increase the SOC buffer **255** when the measured SOC data **215** is comparably high. In some examples during charging, the SOC buffer **255** is reset, i.e. set to zero, when the energy source **14** is substantially fully charged.

Generally, the SOC provider **260** is configured to provide the filtered SOC data **265** as a previous filtered SOC data decreased by the measured SOC decrease rate **225.** Responsive to the SOC decrease rate determiner **220** determining that the SOC decrease rate **225** is above the expected SOC decrease rate **203** (strictly above or by the SOC decrease rate threshold **203T**), i.e. that a SOC masking is to take place, the filtered SOC data **265** is provided as the precious filtered SOC data decreased by the measured SOC decrease rate **225** and increased by the SOC correction **245.** Generally, whenever the SOC buffer controller **250** increases the SOC buffer **255**, the SOC provider **260** is configured to decrease the filtered SOC data **265** correspondingly. Analogously, whenever the SOC buffer controller **250** decreases the SOC buffer **255,** the SOC provider **260** is configured to increase the filtered SOC data **265** correspondingly.

In some examples, the SOC buffer controller **250** may be configured to compare the measured SOC data **215** to one or more SOC thresholds **201.** For example, the one or more SOC thresholds **201** comprises a predetermined maximum SOC threshold **206,** an intermediate SOC threshold **204** and/or the minimum SOC threshold **202.**

The predetermined maximum SOC threshold **206** may be chosen freely, and may be chosen to indicate at what SOC the energy source **14** is considered to be full, i.e. the SOC is 100 %. The maximum SOC threshold **206** does not necessarily correspond to a physical maximum energy level of the energy source **14,** but may be a level slightly below the physical maximum energy level. This generally increases a lifetime of the energy source and allows for an increased number of charging/discharging cycles. In some examples, the maximum SOC threshold **206** may be configured to be at a level that is below a SOC at which the energy source **14** is considered to be full (which in turn may be below the physical maximum energy level of the energy source **14**).

The minimum SOC threshold **202** may be a threshold indicating at what SOC the energy source **14** is considered to be empty, i.e. the SOC is 0 %. The minimum SOC threshold **202** does not necessarily correspond to a physical minimum energy level of the energy source **14,** but may be a level slightly above the physical minimum energy level. Correspondingly to the maximum SOC threshold **206,** this generally increases a lifetime of the energy source and allows for an increased number of charging/discharging cycles. As will be explained, the minimum SOC threshold **202** may be a configurable threshold.

The intermediate SOC threshold **204** is a threshold indicating a SOC value of the energy source between the minimum SOC threshold **202** and the maximum SOC threshold 206. In some examples, the intermediate SOC threshold **204** is somewhere between 25 % and 75 % of a total SOC of the energy source **14.** In some examples, the intermediate SOC threshold **204** is at 35 % of the total SOC of the energy source **14.** In some examples, the intermediate SOC threshold **204** is at 65 % of the total SOC of the energy source **14.** In some examples, the intermediate SOC threshold **204** is at 50 % of the total SOC of the energy source **14.** As the risk of recalibration events and jumps in the measured SOC data **215** may increase as the measured SOC data **215** closes in on the minimum SOC threshold **202,** in some examples, the intermediate SOC threshold **204** is at 10 percent points above the minimum SOC threshold **202.** In some examples the intermediate SOC threshold **204** is at 5 percent points above the minimum SOC threshold **202.**

In some examples, during discharge of the energy source **14,** responsive to the SOC buffer controller **250** determining that the measured SOC data **215** is between the intermediate SOC **204** and the maximum SOC threshold **206,** the SOC buffer controller **250** may be configured to increase the SOC buffer **255.** The SOC buffer controller **250** may be configured to increase the SOC buffer **255** each time an updated measured SOC data **215** is obtained, periodically based on a predetermined time period, depending on the SOC decrease rate **225,** depending on the SOC difference **235** or combinations thereof. The SOC buffer controller **250** may be configured to increase the SOC buffer **255** by any suitable amount. In some examples, the SOC buffer controller **250** is configured to increase the SOC buffer **255** by an SOC increase value **256.** The SOC increase value **256** may be a predetermined fixed value. In some examples, the SOC buffer controller **250** is configured to determine the SOC increase value **256** as a function of the measured SOC data **215.** The SOC buffer controller **250** may be configured to determine the SOC increase value **256** based on a predetermined or configurable SOC buffer increase rate.

In order to limit the SOC buffer **255,** the SOC buffer controller **250** may be configured to limit the SOC buffer **255** at a predetermined maximum SOC buffer value **258.** That is to say, the SOC buffer controller **250** may be configured to increase the SOC buffer **255** as indicated above, until the SOC buffer **255** reaches the maximum SOC buffer value **258,** at which point, the SOC buffer **255** is, unless an SOC correction **245** is determined, maintained at the maximum SOC buffer value **258.** The SOC increase value **256** and/or the SOC decrease value **252** may be determined based on a difference between the maximum SOC buffer value **258** and the SOC buffer **255.** As indicated, if the SOC buffer **255** is equal to the maximum SOC buffer value **258,** the SOC increase value **256** may be set to zero. Additionally, or alternatively, as the SOC buffer **255** approaches the maximum SOC buffer value **258,** the SOC increase value **256** may de decreased.

In some examples, during discharge of the energy source **14,** responsive to the SOC buffer controller **250** determining that the measured SOC data **215** is between the intermediate SOC **204** and the minimum SOC threshold **202,** the SOC buffer controller **250** may be configured to decrease the SOC buffer **255.** The SOC buffer controller **250** may be configured to decrease the SOC buffer **255** each time an updated measured SOC data **215** is obtained, periodically based on a predetermined time period, depending on the SOC decrease rate **225,** depending on the SOC difference **235** or combinations thereof. The SOC buffer controller **250** may be configured to decrease the SOC buffer **255** by any suitable amount. In some examples, the SOC buffer controller **250** is configured to increase the SOC buffer **255** by an SOC decrease value **252.** The SOC decrease value **252** may be a predetermined fixed value. In some examples, the SOC buffer controller **250** is configured to determine the SOC decrease value **252** as a function of the measured SOC data **215.** The SOC buffer controller **250** may be configured to determine the SOC decrease value **252** based on a predetermined or configurable SOC buffer decrease rate. In some examples, the SOC decrease value **252** is configured such that the SOC buffer **255** is substantially zero when the measured SOC data **215** is at the minimum SOC threshold **202.**

In some examples, in order to detect positive shifts, i.e. sudden increases in the measured SOC data **215,** the SOC decrease rate determiner **220,** may be configured to compare the measured SOC decrease rate **225** to an SOC increase rate threshold **203T2.** The SOC increase rate threshold **203T2** may be of the corresponding magnitude as the expected SOC decrease rate threshold **203T** or configured independently of the SOC decrease rate threshold **203T.** If the SOC decrease rate determiner **220** determines that the measured SOC decrease rate **225** is at or above the SOC increase rate threshold **203T2,** the SOC difference determiner **230,** the SOC correction determiner **240,** the SOC buffer controller **250** and the SOC provider **260** may be configured to operate as previously described but by increasing the SOC buffer **255** by the SOC correction **245** and providing the filtered SOC data **285** as the measured SOC data **215** decreased by the SOC correction **245.**

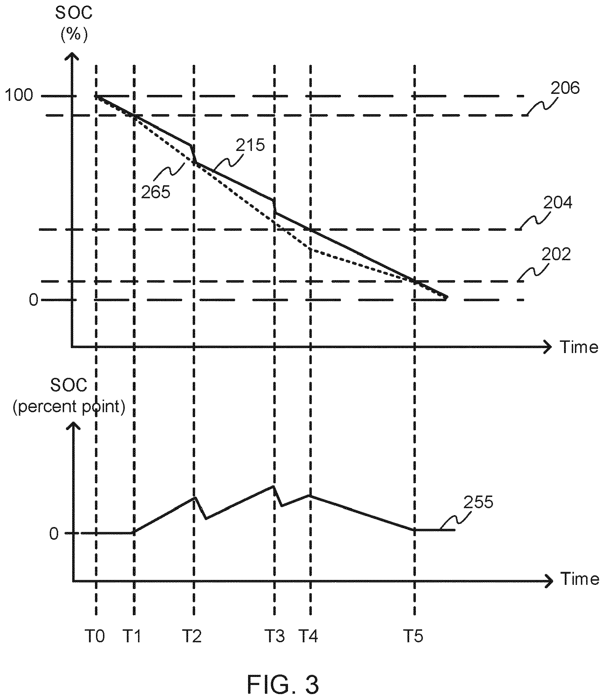

With reference to **FIG 3****,** **FIG. 4** and **FIG. 5****,** some non-limiting examples of how the SOC masker **200** may function will be presented. In both **FIG 3****,** **FIG. 4** and **FIG. 5****,** a top diagram showing SOC in percentage versus time is provided together with a bottom diagram showing the SOC buffer **255** in percentage points of SOC versus time. The time axes are aligned for the top and bottom diagrams. The top diagrams all indicate 100 % SOC as their maximum value, this is to be considered to be the level at which the energy source **14** is considered to be fully charged, i.e. not necessarily the physical maximum energy level of the energy source **14.** It should be mentioned that the neither the top, nor the bottom diagrams are to scale on their vertical SOC axis. Also, drops/shifts in SOC are exaggerated in order to improve visibility. **FIG 3****,** **FIG. 4** and **FIG. 5** are provided to explain different scenarios and implementation examples, and not to accurately represent physical processes in an energy source **14.**

In **FIG. 3****,** the SOC buffer **255** is a truly virtual buffer that is provided to mask the measured SOC data **215.** At a discharge start time **T0,** the SOC buffer **255** is zero (empty) and the SOC of the energy source **14** is 100 %. This means that the measured SOC data **215** and the filtered SOC data **265** are the same. At the discharge start time **T0,** discharging of the energy source **14** starts, but since the measured SOC data **215** is above the maximum SOC threshold **206** and above the SOC intermediate threshold **204,** the SOC buffer **255** remains empty. At a first point in time **T1,** the measured SOC data **215** is at the maximum SOC threshold **206.** As a consequence, the SOC buffer **255** is increased by the SOC increase value **256** which can be seen in the lower diagram in **FIG. 3****.** As the SOC buffer **255** is increased, the filtered SOC data **265** is decreased correspondingly, which can be seen in the upper diagram of **FIG. 3** by the filtered SOC data **265** diverging from the measured SOC data **215.** At a second point in time **T2,** a shift in the measured SOC data **215** occurs. This shift causes the measured SOC decrease rate **225** to be above the expected SOC decrease rate **203** and as a consequence, the SOC buffer **255** is decreased correspondingly to the shift in measured SOC data **215** but no shift in the filtered SOC data **265** occurs due to the SOC buffer **255** compensating for the shift. As the measured SOC data **215** is still below the maximum SOC threshold **206** and above the SOC intermediate threshold **204,** the SOC buffer **255** is increased further also after the second point in time **T2.** At a third point in time **T3,** another shift in the measured SOC data **215** occurs. As before, this shift causes the measured SOC decrease rate **225** to be above the expected SOC decrease rate **203** and as a consequence, the SOC buffer **255** is decreased correspondingly to the shift in measured SOC data **215** but no shift in the filtered SOC data **265** occurs due to the SOC buffer **255** compensating for the shift. As the measured SOC data **215** is still below the maximum SOC threshold **206** and above the SOC intermediate threshold **204,** the SOC buffer **255** is increased further also after the second point in time **T3.** However, at a fourth point in time **T4,** the measured SOC data **215** is at the intermediate SOC threshold **204,** causing a decrease of the SOC buffer **255** by the SOC decrease value **252.** This can be seen by the SOC buffer **255** reducing in the lower diagram of **FIG. 3****.** As the SOC buffer **255** is decreased by the SOC decrease value **252,** the filtered SOC data **265** is increased correspondingly which can be seen upper diagram of **FIG. 3** by the filtered SOC data **265** converging towards the measured SOC data **215.** At a fifth point in time **T5,** the measured SOC data **215** is at the minimum SOC threshold **202** at which point **T5** the propulsion of the vehicle **10** is prohibited. Also, at the fifth point in time **T5**, the SOC buffer **255** is substantially empty.

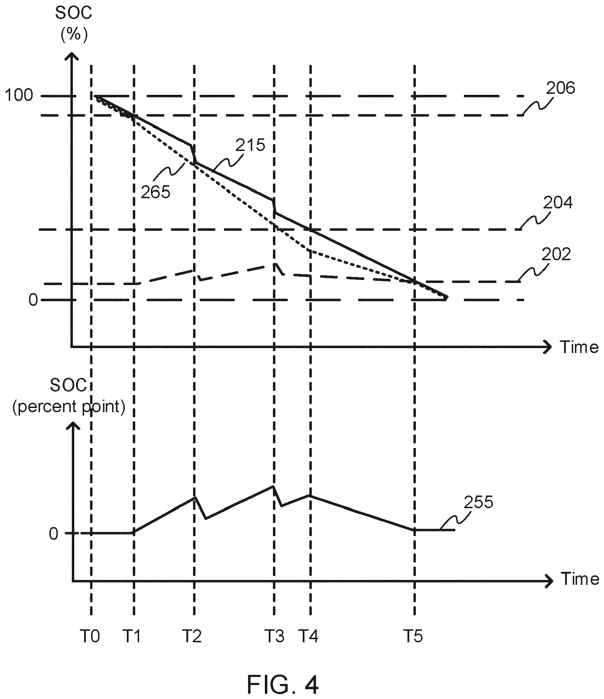

In **FIG. 4****,** the SOC buffer **255** may be referred to as a semi-virtual buffer (at least in comparison to the SOC buffer **255** of **FIG. 3**) that is provided to mask the measured SOC data **215.** At a discharge start time **T0,** the SOC buffer **255** is zero (empty) and the SOC of the energy source **14** is 100 %. This means that the measured SOC data **215** and the filtered SOC data **265** are the same. At the discharge start time **T0,** discharging of the energy source **14** starts, but since the measured SOC data **215** is above the maximum SOC threshold **206** and above the SOC intermediate threshold **204,** the SOC buffer **255** remains empty. At a first point in time **T1,** the measured SOC data **215** is at the maximum SOC threshold **206.** As a consequence, the SOC buffer **255** is increased by the SOC increase value **256** which can be seen in the lower diagram in **FIG. 4****.** In **FIG. 4**, the increase of the SOC buffer **255** is provided by an increase of the minimum SOC threshold **202.** This means that the SOC buffer **255** is provided by a difference between a current minimum SOC threshold **202,** and the minimum SOC threshold **202** at the first time point **T1.** As the SOC buffer **255** is increased, the filtered SOC data **265** is decreased correspondingly, which can be seen in the upper diagram of **FIG. 4** by the filtered SOC data **265** diverging from the measured SOC data **215.** At a second point in time **T2,** a shift in the measured SOC data **215** occurs. This shift causes the measured SOC decrease rate **225** to be above the expected SOC decrease rate **203** and as a consequence, the SOC buffer **255** is decreased correspondingly to the shift in measured SOC data **215** but no shift in the filtered SOC data **265** occurs due to the SOC buffer **255** compensating for the shift. As the SOC buffer **255** decreases, so does the minimum SOC threshold **202.** As the measured SOC data **215** is still below the maximum SOC threshold **206** and above the SOC intermediate threshold **204,** the SOC buffer **255** and consequently the minimum SOC threshold **202** is increased further also after the second point in time **T2.** At a third point in time **T3,** another shift in the measured SOC data **215** occurs. As before, this shift causes the measured SOC decrease rate **225** to be above the expected SOC decrease rate **203** and as a consequence, the SOC buffer **255** and thereby the minimum SOC threshold **202** is decreased correspondingly to the shift in measured SOC data **215** but no shift in the filtered SOC data **265** occurs due to the SOC buffer **255** compensating for the shift. As the measured SOC data **215** is still below the maximum SOC threshold **206** and above the SOC intermediate threshold **204,** the SOC buffer **255** is increased further also after the second point in time **T3.** However, at a fourth point in time **T4,** the measured SOC data 215 is at the intermediate SOC threshold **204,** and decreasing of the SOC buffer **255** by the SOC decrease value **252.** This can be seen by the SOC buffer **255** reducing in the lower diagram of **FIG. 4** and the minimum SOC threshold **202** returning to the level of the minimum SOC threshold **202** at the start time **T0.** As the SOC buffer **255** is decreased by the SOC decrease value **252,** the filtered SOC data **265** is increased correspondingly which can be seen upper diagram of **FIG. 4** by the filtered SOC data **265** converging towards the measured SOC data **215.** At a fifth point in time **T5,** the measured SOC data **215** is at the minimum SOC threshold **202** (which is at the corresponding level as the minimum SOC threshold **202** at the start time **T0**) at which point **T5** the propulsion of the vehicle **10** is prohibited. Also, at the fifth point in time **T5,** the SOC buffer **255** is substantially empty.

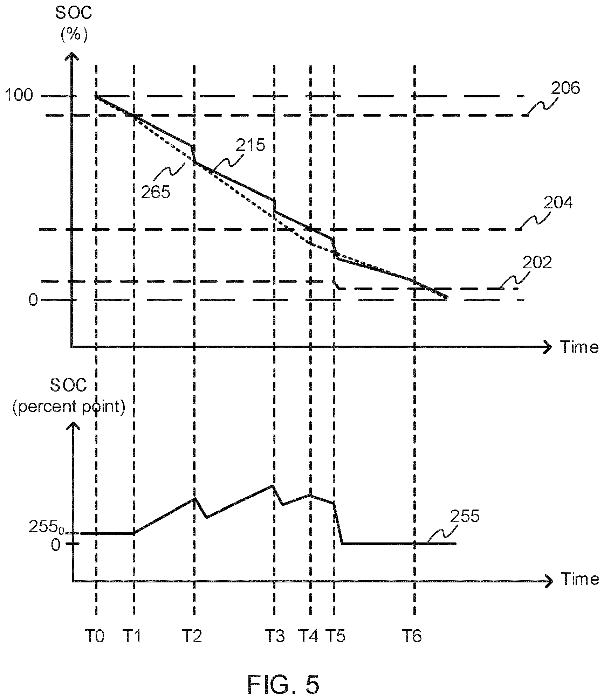

In **FIG. 5****,** the SOC buffer **255** may be described as a combination of the SOC buffer **255** exemplified in **FIG. 3** and a variant of the SOC buffer **255** exemplified in **FIG. 4****.** In **FIG. 5****,** at a discharge start time **T0,** the SOC buffer **255** is at an initial SOC buffer level **255₀** and the SOC of the energy source **14** is 100 %. However, even though the initial SOC buffer level **255₀** is greater than zero, the measured SOC data **215** and the filtered SOC data **265** are the same at the discharge start time **T0.** At the discharge start time **T0,** discharging of the energy source **14** starts, but since the measured SOC data **215** is above the maximum SOC threshold **206** and above the SOC intermediate threshold **204,** the SOC buffer **255** remains empty. At a first point in time **T1**, the measured SOC data **215** is at the maximum SOC threshold **206.** As a consequence, the SOC buffer **255** is increased by the SOC increase value **256** which can be seen in the lower diagram in **FIG. 5****.** As the SOC buffer **255** is increased, the filtered SOC data **265** is decreased correspondingly, which can be seen in the upper diagram of **FIG. 3** by the filtered SOC data **265** diverging from the measured SOC data **215.** At a second point in time **T2,** a shift in the measured SOC data **215** occurs. This shift causes the measured SOC decrease rate **225** to be above the expected SOC decrease rate **203** and as a consequence, the SOC buffer **255** is decreased correspondingly to the shift in measured SOC data **215** but no shift in the filtered SOC data **265** occurs due to the SOC buffer **255** compensating for the shift. As the measured SOC data **215** is still below the maximum SOC threshold **206** and above the SOC intermediate threshold **204,** the SOC buffer **255** is increased further also after the second point in time **T2.** At a third point in time **T3,** another shift in the measured SOC data **215** occurs. As before, this shift causes the measured SOC decrease rate **225** to be above the expected SOC decrease rate **203** and as a consequence, the SOC buffer **255** is decreased correspondingly to the shift in measured SOC data **215** but no shift in the filtered SOC data **265** occurs due to the SOC buffer **255** compensating for the shift. As the measured SOC data **215** is still below the maximum SOC threshold **206** and above the SOC intermediate threshold **204,** the SOC buffer **255** is increased further also after the second point in time **T3.** However, at a fourth point in time **T4,** the measured SOC data **215** is at the intermediate SOC threshold **204,** and decreasing of the SOC buffer **255** by the SOC decrease value **252.** This can be seen by the SOC buffer **255** reducing in the lower diagram of **FIG. 5****.** As the SOC buffer **255** is decreased by the SOC decrease value **252,** the filtered SOC data **265** is increased correspondingly which can be seen upper diagram of **FIG. 5** by the filtered SOC data **265** converging towards the measured SOC data **215.** At a fifth point in time **T5,** a third shift in the measured SOC data **215** occurs. As before, this shift causes the measured SOC decrease rate **225** to be above the expected SOC decrease rate **203.** However, the shift is greater than the remainder of what has been accumulated by the SOC buffer **255** from the first point in time **T1.** In some examples, this would cause the SOC buffer **255** to be emptied leaving a shift, admittedly a reduced shift from that of the measured SOC data **215,** in the filtered SOC data **265.** However, as the SOC buffer **255** had was configured at the initial SOC buffer level **255₀** at the start time **T0,** the SOC buffer **255** may be further reduced. The initial SOC buffer level **255₀** is provided by the minimum SOC threshold **202,** and the shift in measured SOC data **215** may be compensated by reducing the minimum SOC threshold **202,** see upper diagram of the **FIG. 5****.** As a result, the measured SOC data **215** is below the filtered SOC data **265** after the fifth point in time **T5.** Discharge of the energy source proceeds and the filtered SOC data **265** is decreased such that the measured SOC data **215** and the filtered SOC data **265** are equal before, or at, a sixth point in time **T6** at which point the measured SOC data **215** is at the minimum SOC threshold **202** and propulsion of the vehicle **10** is prohibited.

The examples presented with reference to **FIG 3****,** **FIG. 4** and **FIG. 5** are, as mentioned, non-limiting examples provided to explain some, but not all, features of the SOC masker **200** introduced with reference to **FIG. 2****.** For instance, the SOC buffer **255** reaching the SOC maximum buffer value **258** is not explicitly shown, but is well within the scope of all examples presented herein. Further, in **FIG 3****,** **FIG. 4** and **FIG. 5****,** the shifts in measured SOC data **215** are substantially removed in the filtered SOC data **265.** However, as mentioned, in some examples, the SOC correction **240** may is not necessarily equal to the SOC difference **235** and shifts also in the filtered SOC data **265** may be permitted.

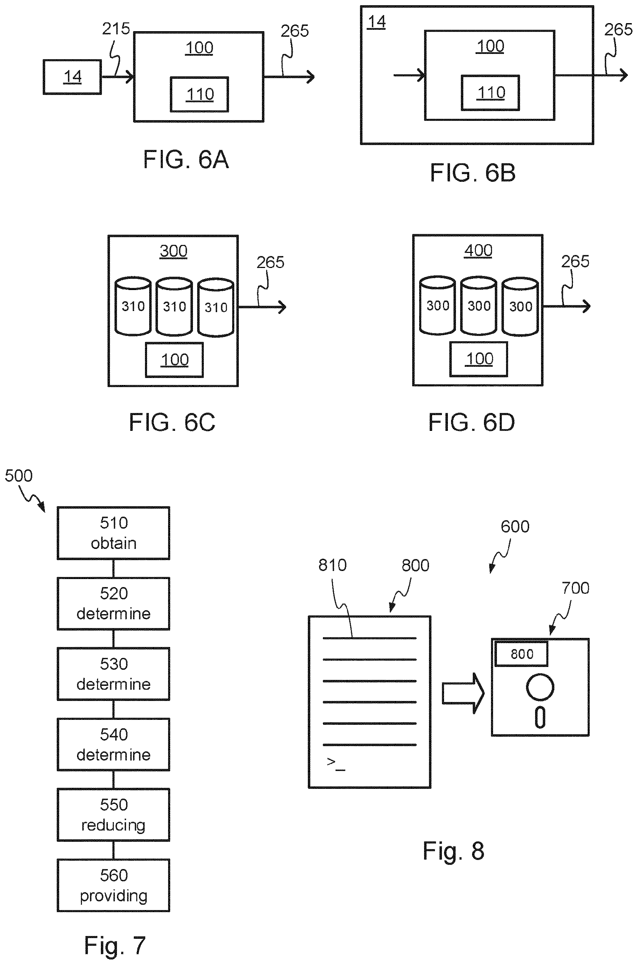

As indicated, the computer system **100** may be configured to provide, or cause, the functionality of the SOC masker **200.** To this end, as indicated in **FIG. 6A****,** the computer system **100** may be operatively connected to the energy source **14** and configured to obtain measured SOC data **215** from the energy source **14** and provide filtered SOC data **265** for further processing.

In one specific example, the computer system **100** of e.g. **FIG. 6A** comprises processing circuitry **110** configured to obtain measured SOC data **215** of an energy source **14** of a vehicle **10.** The processing circuitry **110** is further configured to determine that a measured SOC decrease rate **225** is above an expected SOC decrease rate **203** by a predetermined SOC decrease rate threshold **203T** and to determine an SOC difference **235** based on the measured SOC data **215** and the expected SOC decrease rate **203.** The processing circuitry **110** is further configured to determine an SOC correction **245** based on the SOC difference **235,** reduce an SOC buffer **255** of the energy source **14** by the SOC correction **245,** and provide filtered SOC data **265** of the energy source **14** by increasing the measured SOC data **215** by the SOC correction **245.**

In some examples, see **FIG. 6B****,** the computer system **100,** or at least processing circuitry **110** forming part of the computer system **100,** may form part of the energy source **14.** The computer system **100** may be configured to obtain measured SOC data **215** of the energy source **14** and provide filtered SOC data **265** for further processing.

The computer system **100** may be part of a battery pack **300,** see **FIG. 6C****.** The battery pack **300** may comprise one or more battery cells **310.** The computer system **100** may be configured to obtain measured SOC data **215** from at least one of the one or more battery cells **310** and provide filtered SOC data **265** for further processing.

In some examples, see **FIG. 6D****,** the computer system **100** may form part of an energy management system **400.** The energy management system **400** comprises one or more battery packs **300,** e.g. the battery pack **300** of **FIG. 6C****.** The computer system **100** may be configured to obtain measured SOC data **215** from at least one of the one or more battery packs **300** and provide filtered SOC data **265** for further processing.

As indicated in the previous, the functionality of the SOC masker **200** may be provided at substantially any or all levels of an energy supply of a vehicle **10.** One or more battery cells **310** may comprise processing circuitry **110** configured to perform the functionality of the SOC masker **200** and provide filtered SOC data **265** for further processing. The filtered SOC data **265** from the battery cell **310** may be obtained as measured SOC data **215** by processing circuitry **110** of a battery pack **300** configured to perform the functionality of the SOC masker **200** and provide filtered SOC data **265** for further processing. The filtered SOC data **265** from the battery pack **300** may be obtained as measured SOC data **215** by processing circuitry **110** of a battery management system **400** configured to perform the functionality of the SOC masker **200** and provide filtered SOC data **265** for further processing.

With reference to **FIG. 7****,** a method **500** according to one example of the present disclosure will be presented. The method **500** may be a partly, or wholly, computer implemented method **500.** In some examples, the computer system **100,** or rather processing circuitry **110** of the computer system **100** introduced with reference to **FIG. 1****,** may be configured to perform, or cause performance of, any or all features of the method **500.** The method **500** may be described as a method **500** for SOC masking.

The method **500** comprises obtaining **510** measured state of charge, SOC, data **215** of an energy source **14** of a vehicle **10.** The obtaining **510** may be provided as outlined e.g. in reference to the SOC obtainer **210** introduced with reference to **FIG. 2****.** The method **500** further comprises determining **520** that a measured SOC decrease rate **225** is above an expected SOC decrease rate **203** by a predetermined SOC decrease rate threshold **203T.** This determining **530** may be provided as outlined e.g. in reference to the SOC decrease rate determiner **220** introduced with reference to **FIG. 2****.** The method **500** further comprises determining **530** an SOC difference **235** based on the measured SOC data **215** and the expected SOC decrease rate **203.** This determining **530** may be provided as outlined e.g. in reference to the SOC difference determiner **230** introduced with reference to **FIG. 2****.** The method **500** further comprises determining **540** an SOC correction **245** based on the SOC difference **235.** This determining **540** may be provided as outlined with reference to the SOC correction determiner **240** introduced with reference to **FIG. 2****.** The method **500** further comprises reducing **550** an SOC buffer **255** of the energy source **14** by the SOC correction **245.** Reducing the SOC buffer **255** may be provided as outlined e.g. in reference to the SOC buffer controller **250** introduced with reference to **FIG. 2****.** The method **500** further comprises providing **560** filtered SOC data **265** of the energy source **14** by increasing the measured SOC data **215** by the SOC correction **245.** The providing **560** may be provided as outlined e.g. in reference to the SOC provider **560** introduced with reference to **FIG. 2****.**

The method **500** of **FIG. 7****,** may be modified, expanded or otherwise altered to comprise any or all features, examples or functions presented herein, e.g. in reference to the SOC masker introduced in reference to **FIG. 2****.**

In **FIG. 8** a computer program product **600** is shown. The computer program product 6**00** comprises a computer program **800** and a non-transitory computer readable medium **700.** The computer program **800** may be stored on the computer readable medium **700.** The computer readable medium **700** is, in **FIG. 8****,** exemplified as a vintage 5,25" floppy disc, but may be embodied as any suitable non-transitory computer readable medium such as, but not limited to, hard disk drives (HDDs), solid-state drives (SSDs), optical discs (e.g., CD-ROM, DVD-ROM, CD-RW, DVD-RW), USB flash drives, magnetic tapes, memory cards, Read-Only Memories (ROM), network-attached storage (NAS), cloud storage etc.

The computer program **800** comprises instruction **810** e.g. program instruction, software code, that, when executed by processing circuitry cause the processing circuitry to perform the method **500** introduced with reference to **FIG. 7****.**

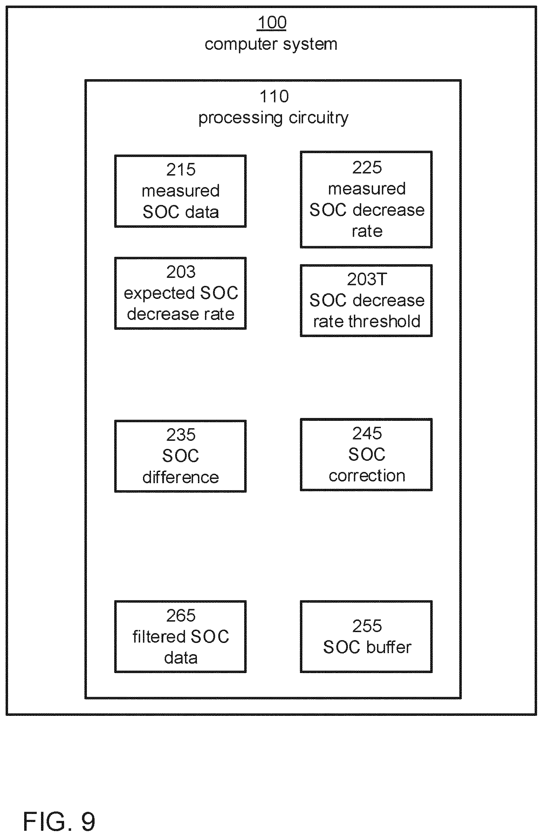

With reference to **FIG. 9****,** a computer system **100** is shown. The computer system **100** comprises processing circuitry **110** configured to obtain measured state of charge, SOC, data **215** of an energy source **14** of a vehicle **10,** and determine that a measured SOC decrease rate **225** is above an expected SOC decrease rate **203** by a predetermined SOC decrease rate threshold **203T.** The processing circuitry **110** is further configured to determine an SOC difference **235** based on the measured SOC data **215** and the expected SOC decrease rate **203,** to determine an SOC correction **245** based on the SOC difference **235,** to reduce an SOC buffer **255** of the energy source **14** by the SOC correction **245;** and to provide filtered SOC data **265** of the energy source **14** by increasing the measured SOC data **215** by the SOC correction **245.**

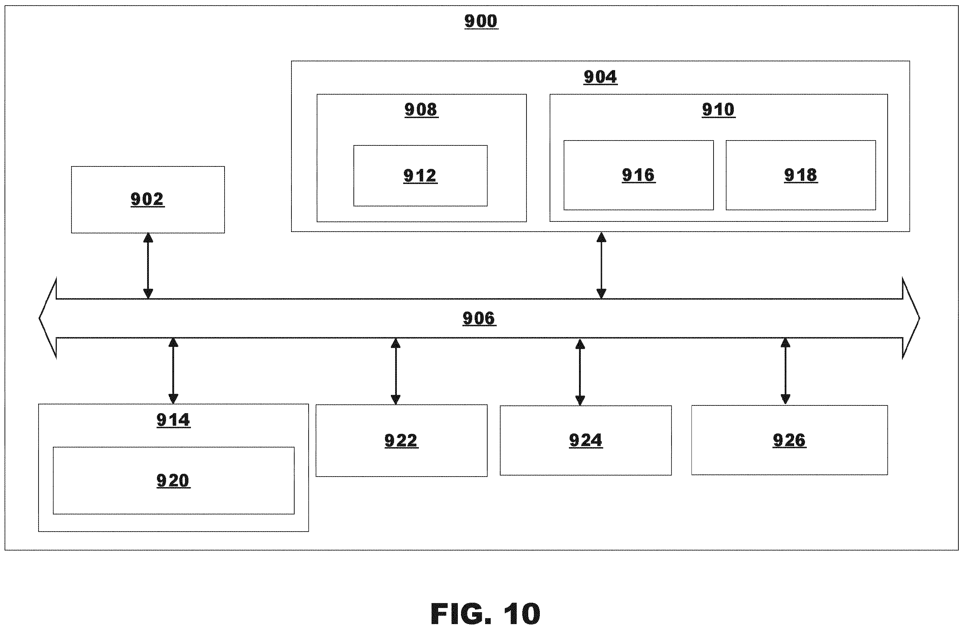

**FIG. 10** is a schematic diagram of a computer system **900** for implementing examples disclosed herein. The computer system **900** may be the computer system **100** introduced with reference to **FIG. 1****.** The computer system **900** is adapted to execute instructions from a computer-readable medium to perform these and/or any of the functions or processing described herein. The computer system **900** may be connected (e.g., networked) to other machines in a LAN, an intranet, an extranet, or the Internet. While only a single device is illustrated, the computer system **900** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **900** may comprise at least one computing device or electronic device capable of including firmware, hardware, and/or executing software instructions to implement the functionality described herein. The computer system **900** may include processing circuitry **902** (e.g., processing circuitry including one or more processor devices or control units), a memory **904,** and a system bus **906.** The processing circuitry **902** may comprise the processing circuitry **110** of the computer system **100** introduced with reference to **FIG. 1****.** The computer system **900** may include at least one computing device having the processing circuitry **902.** The system bus **906** provides an interface for system components including, but not limited to, the memory **904** and the processing circuitry **902.** The processing circuitry **902** may include any number of hardware components for conducting data or signal processing or for executing computer code stored in memory **904.** The processing circuitry **902** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **902** may further include computer executable code that controls operation of the programmable device.

The system bus **906** may be any of several types of bus structures that may further interconnect to a memory bus (with or without a memory controller), a peripheral bus, and/or a local bus using any of a variety of bus architectures. The memory **904** may be one or more devices for storing data and/or computer code for completing or facilitating methods described herein. The memory **904** may include database components, object code components, script components, or other types of information structure for supporting the various activities herein. Any distributed or local memory device may be utilized with the systems and methods of this description. The memory **904** may be communicably connected to the processing circuitry **902** (e.g., via a circuit or any other wired, wireless, or network connection) and may include computer code for executing one or more processes described herein. The memory **904** may include non-volatile memory **908** (e.g., read-only memory (ROM), erasable programmable read-only memory (EPROM), electrically erasable programmable read-only memory (EEPROM), etc.), and volatile memory **910** (e.g., random-access memory (RAM)), or any other medium which can be used to carry or store desired program code in the form of machine-executable instructions or data structures and which can be accessed by a computer or other machine with processing circuitry **902.** A basic input/output system (BIOS) **912** may be stored in the non-volatile memory **908** and can include the basic routines that help to transfer information between elements within the computer system **900.**

The computer system **900** may further include or be coupled to a non-transitory computer-readable storage medium such as the storage device **914,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **914** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **914** and/or in the volatile memory **910,** which may include an operating system **916** and/or one or more program modules **918.** All or a portion of the examples disclosed herein may be implemented as a computer program **920** stored on a transitory or non-transitory computer-usable or computer-readable storage medium (e.g., single medium or multiple media), such as the storage device **914,** which includes complex programming instructions (e.g., complex computer-readable program code) to cause the processing circuitry **902** to carry out actions described herein. Thus, the computer-readable program code of the computer program **920** can comprise software instructions for implementing the functionality of the examples described herein when executed by the processing circuitry **902.** In some examples, the storage device **914** may be a computer program product (e.g., readable storage medium) storing the computer program **920** thereon, where at least a portion of a computer program **920** may be loadable (e.g., into a processor) for implementing the functionality of the examples described herein when executed by the processing circuitry **902.** The processing circuitry **902** may serve as a controller or control system for the computer system **900** that is to implement the functionality described herein.

The computer system **900** may include an input device interface **922** configured to receive input and selections to be communicated to the computer system **900** when executing instructions, such as from a keyboard, mouse, touch-sensitive surface, etc. Such input devices may be connected to the processing circuitry **902** through the input device
interface **922** coupled to the system bus **906** but can be connected through other interfaces, such as a parallel port, an Institute of Electrical and Electronic Engineers (IEEE) 1394 serial port, a Universal Serial Bus (USB) port, an IR interface, and the like. The computer system **900** may include an output device interface **924** configured to forward output, such as to a display, a video display unit (e.g., a liquid crystal display (LCD) or a cathode ray tube (CRT)). The computer system **900** may include a communications interface **926** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

In the following, a number of specific examples of the present disclosure will be presented. The scope of the invention is defined by the appended claims.

Example 1. A computer system **100** comprising processing circuitry **110** configured to: obtain measured state of charge, SOC, data **215** of an energy source **14** of a vehicle **10,** determine that a measured SOC decrease rate **225** is above an expected SOC decrease rate **203** by a predetermined SOC decrease rate threshold **203T;** determine an SOC difference **235** based on the measured SOC data **215** and the expected SOC decrease rate **203;** determine an SOC correction **245** based on the SOC difference **235;** reduce an SOC buffer **255** of the energy source **14** by the SOC correction **245;** and provide filtered SOC data **265** of the energy source **14** by increasing the measured SOC data **215** by the SOC correction **245.**

Example 2. The computer system 100 of example 1, wherein the processing circuitry is further configured to: determine the expected SOC decrease rate **203** based on energy drained from the energy source **14.**

Example 3. The computer system **100** of example 1 or 2, wherein the processing circuitry **110** is further configured to: determine that the measured SOC data **215** is below a predetermined maximum SOC threshold **206** and above an intermediate SOC threshold **204;** increase the SOC buffer **255** by a SOC increase value **256;** and provide filtered SOC data **265** of the energy source **14** by decreasing the measured SOC data **215** by the SOC increase value **256.**

Example 4. The computer system **100** of example 3, wherein the processing circuitry **110** is further configured to: determine the SOC increase value **256** as a function of the measured SOC data **215.**

Example 5. The computer system **100** of example 3, wherein the processing circuitry **110** is further configured to: determine the SOC increase value **256** at a predetermined fixed value.

Example 6. The computer system **100** of any one of examples 1 to 5, wherein the processing circuitry **110** is further configured to: determine that the measured SOC data **215** is below the intermediate SOC threshold **204** and above a minimum SOC threshold **202;** decrease the SOC buffer **255** by a SOC decrease value **252;** and provide filtered SOC data **265** of the energy source **14** by increasing the measured SOC data **215** by the SOC decrease value **252.**

Example 7. The computer system **100** of example 6, wherein the processing circuitry **110** is further configured to: determine the SOC decrease value **252** as a function of the measured SOC data **215.**

Example 8. The computer system **100** of example 7, wherein the processing circuitry **110** is further configured to: determine the SOC decrease value **252** at a predetermined fixed value.

Example 9. The computer system **100** of any one of examples 1 to 8, wherein the processing circuitry **110** is further configured to: limit the SOC buffer **255** at a predetermined maximum SOC buffer value **258.**

Example 10. The computer system 100 of any one of examples 1 to 9, wherein the processing circuitry **110** is further configured to: prevent propulsion of the vehicle **10** responsive to the measured SOC data **215** being below a minimum SOC threshold **202.**

Example 11. The computer system **100** of example 6 and 10, wherein the processing circuitry **110** is further configured to: determine the SOC decrease value **252** such that the SOC buffer **255** is substantially zero when the measured SOC data **215** is at the minimum SOC threshold **202.**

Example 12. The computer system **100** of example 11, wherein the processing circuitry 110 is further configured to: determine that the SOC difference **235** is greater than the SOC buffer **255;** and reduce the minimum SOC threshold **202** by the by the SOC correction **245.**

Example 13. The computer system 100 of example any one of examples 1 to 9, wherein SOC buffer **255** is equal to a minimum SOC threshold **202,** and the processing circuitry **110** is further configured to: prevent propulsion of the vehicle **10** responsive to the measured SOC data **215** being below the minimum SOC threshold **202.**

Example 14. The computer system 100 of any one of examples 1 to 13, wherein the processing circuitry 110 is further configured to: determine that a SOC decrease rate **225** is above the expected SOC decrease rate **203** by comparing measured SOC data **215** to previous measured SOC data **215.**

Example 15. The computer system 100 of any one of example 1 to 14, wherein the processing circuitry **110** is further configured to: determine that a SOC decrease rate **225** is above the expected SOC decrease rate **203** by obtaining a SOC data calibration event indicator **14c** from the energy source **14.**

Example 16. The computer system **100** of example 1, wherein the processing circuitry **110** is further configured to: determine the processing circuitry **110** is further configured to: determine that a SOC decrease rate **225** is above the expected SOC decrease rate **203** by obtaining a SOC data calibration event indicator **14c** from the energy source **14;** expected SOC decrease rate **203** based on energy drained from the energy source **14;** determine that the measured SOC data **215** is below a predetermined maximum SOC threshold **206** and above an intermediate SOC threshold **204;** increase the SOC buffer **255** by a SOC increase value **256;** and provide filtered SOC data **265** of the energy source **14** by decreasing the measured SOC data **215** by the SOC increase value **256;** determine the SOC increase value **256** as a function of the measured SOC data **215;** determine the SOC increase value **256** at a predetermined fixed value; determine that the measured SOC data **215** is below the intermediate SOC threshold **204** and above a minimum SOC threshold **204;** decrease the SOC buffer **255** by a SOC decrease value **252;** and provide filtered SOC data **265** of the energy source **14** by increasing the measured SOC data **215** by the SOC decrease value **252;** determine the SOC decrease value **252** as a function of the measured SOC data **215;** determine the SOC decrease value **252** at a predetermined fixed value; limit the SOC buffer **255** at a predetermined maximum SOC buffer value **258;** prevent propulsion of the vehicle **10** responsive to the measured SOC data **215** being below a minimum SOC threshold **202;** determine the SOC decrease value **252** such that the SOC buffer **255** is substantially zero when the measured SOC data **215** is at the minimum SOC threshold **202;** determine that the SOC difference **235** is greater than the SOC buffer **255;** and reduce the minimum SOC threshold **202** by the by the SOC correction **245;** determine that a SOC decrease rate **225** is above the expected SOC decrease rate **203** by comparing measured SOC data **215** to previous measured SOC data **215;** and determine that a SOC decrease rate **225** is above the expected SOC decrease rate **203** by obtaining a SOC data calibration event indicator **14c** from the energy source **14**

Example 17. The computer system 100 of example 1, wherein the processing circuitry **110** is further configured to: determine that a SOC decrease rate **225** is above the expected SOC decrease rate **203** by obtaining a SOC data calibration event indicator **14c** from the energy source **14;** determine the expected SOC decrease rate **203** based on energy drained from the energy source **14;** determine that the measured SOC data **215** is below a predetermined maximum SOC threshold **206** and above an intermediate SOC threshold **204;** increase the SOC buffer **255** by a SOC increase value **256;** and provide filtered SOC data **265** of the energy source **14** by decreasing the measured SOC data **215** by the SOC increase value **256;** determine the SOC increase value **256** as a function of the measured SOC data **215;** determine the SOC increase value **256** at a predetermined fixed value; determine that the measured SOC data **215** is below the intermediate SOC threshold **204** and above a minimum SOC threshold **202;** decrease the SOC buffer **255** by a SOC decrease value **252;** and provide filtered SOC data **265** of the energy source **14** by increasing the measured SOC data **215** by the SOC decrease value **252;** determine the SOC decrease value **252** as a function of the measured SOC data **215;** determine the SOC decrease value **252** at a predetermined fixed value; limit the SOC buffer **255** at a predetermined maximum SOC buffer value **258;** wherein SOC buffer **255** is equal to a minimum SOC threshold **202,** and the processing circuitry **110** is further configured to: prevent propulsion of the vehicle **10** responsive to the measured SOC data **215** being below the minimum SOC threshold **202;** determine that a SOC decrease rate **225** is above the expected SOC decrease rate **203** by comparing measured SOC data **215** to previous measured SOC data **215;** and determine that a SOC decrease rate **225** is above the expected SOC decrease rate **203** by obtaining a SOC data calibration event indicator **14c** from the energy source **14.**

Example 18. A battery pack **300,** comprising one or more battery cells **310** and the computer system **100** of any one of examples 1 to 17 configured to obtain measured SOC data **215** of at least one of the one or more battery cells **310.**

Example 19. An energy management system **400,** comprising one or more battery packs **300** and the computer system **100** of any one of examples 1 to 16 configured to obtain measured SOC data **215** of at least one of the one or more battery packs **300.**

Example 20. A vehicle **10** comprising one or more energy sources **14** and the computer system **100** of any one of examples 1 to 17 configured to obtain measured SOC data **215** of at least one of the one or more energy sources **14.**

Example 21. A computer implemented method **500** comprising: obtaining **510,** by processing circuitry **110** of a computer system **100,** measured state of charge, SOC, data **215** of an energy source **14** of a vehicle **10,** determining **520,** by processing circuitry **110** of the computer system **100,** that a measured SOC decrease rate **225** is above an expected SOC decrease rate **203** by a predetermined SOC decrease rate threshold **203T;** determining **530,** by processing circuitry **110** of the computer system **100,** an SOC difference **235** based on the measured SOC data **215** and the expected SOC decrease rate **203;** determining **540,** by processing circuitry **110** of the computer system **100,** an SOC correction **245** based on the SOC difference **235;** reducing **550,** by processing circuitry **110** of the computer system **100,** an SOC buffer **255** of the energy source **14** by the SOC correction **245;** and providing **560,** by processing circuitry 110 of the computer system 100, filtered SOC data **265** of the energy source **14** by increasing the measured SOC data **215** by the SOC correction **245.**

Example 22. A computer program product **600** comprising program code **810** for performing, when executed by processing circuitry **110,** the computer implemented method 500 of example 21.

Example 23. A non-transitory computer-readable storage medium **700** comprising instructions **810,** which when executed by processing circuitry **110,** cause the processing circuitry **110** to perform the computer implemented method **500** of example 21.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system (**100**) comprising processing circuitry (**110**) configured to:
obtain measured state of charge, SOC, data (**215**) of an energy source (**14**) of a vehicle (**10**),
determine that a measured SOC decrease rate (**225**) is above an expected SOC decrease rate (**203**) by a predetermined SOC decrease rate threshold (**203T**);
determine an SOC difference (**235**) based on the measured SOC data (**215**) and the expected SOC decrease rate (**203**);
determine an SOC correction (**245**) based on the SOC difference (**235**);
reduce an SOC buffer (**255**) of the energy source (**14**) by the SOC correction (**245**); and
provide filtered SOC data (**265**) of the energy source (**14**) by increasing the measured SOC data (**215**) by the SOC correction (**245**).

2. The computer system (100) of claim 1, wherein the processing circuitry is further configured to:
determine the expected SOC decrease rate (**203**) based on energy drained from the energy source (**14**).

3. The computer system (**100**) of claim 1 or 2, wherein the processing circuitry (**110**) is further configured to:
determine that the measured SOC data (**215**) is below a predetermined maximum SOC threshold (**206**) and above an intermediate SOC threshold (**204**);
increase the SOC buffer (**255**) by a SOC increase value (**256**); and
provide filtered SOC data (**265**) of the energy source (**14**) by decreasing the measured SOC data (**215**) by the SOC increase value (**256**).

4. The computer system (**100**) of any one of claims 1 to 3, wherein the processing circuitry (**110**) is further configured to:
determine that the measured SOC data (**215**) is below the intermediate SOC threshold (**204**) and above a minimum SOC threshold (**202**);
decrease the SOC buffer (**255**) by a SOC decrease value (**252**); and
provide filtered SOC data (**265**) of the energy source (**14**) by increasing the measured SOC data (**215**) by the SOC decrease value (**252**).

5. The computer system (**100**) of claim 4, wherein the processing circuitry (**110**) is further configured to:
determine the SOC decrease value (**252**) such that the SOC buffer (**255**) is substantially zero when the measured SOC data (**215**) is at the minimum SOC threshold (**202**).

6. The computer system (**100**) of claim any one of claims 1 to 5, wherein the processing circuitry (110) is further configured to:
determine that the SOC difference (**235**) is greater than the SOC buffer (**255**);
reduce a minimum SOC threshold (**202**) by the by the SOC correction (**245**); and
prevent propulsion of the vehicle (**10**) responsive to the measured SOC data (**215**) being below the minimum SOC threshold (**202**).

7. The computer system (100) of claim any one of claims 1 to 5, wherein the SOC buffer (**255**) is equal to a minimum SOC threshold (**202**), and the processing circuitry (**110**) is further configured to:
prevent propulsion of the vehicle (**10**) responsive to the measured SOC data (**215**) being below the minimum SOC threshold (**202**).

8. The computer system (100) of any one of claims 1 to 7, wherein the processing circuitry (110) is further configured to:
determine that a SOC decrease rate (225) is above the expected SOC decrease rate (203) by comparing measured SOC data (215) to previous measured SOC data (215).

9. The computer system (100) of claim 1, wherein the processing circuitry is further configured to: determine the expected SOC decrease rate (203) based on energy drained from the energy source (14); determine that the measured SOC data (215) is below a predetermined maximum SOC threshold (206) and above an intermediate SOC threshold (204), increase the SOC buffer (255) by a SOC increase value (256), and provide filtered SOC data (265) of the energy source (14) by decreasing the measured SOC data (215) by the SOC increase value (256); determine that the measured SOC data (215) is below the intermediate SOC threshold (204) and above a minimum SOC threshold (202), decrease the SOC buffer (255) by a SOC decrease value (252), and provide filtered SOC data (265) of the energy source (14) by increasing the measured SOC data (215) by the SOC decrease value (252); determine the SOC decrease value (252) such that the SOC buffer (255) is substantially zero when the measured SOC data (215) is at the minimum SOC threshold (202); determine that the SOC difference (235) is greater than the SOC buffer (255), reduce a minimum SOC threshold (202) by the by the SOC correction (245), and prevent propulsion of the vehicle (10) responsive to the measured SOC data (215) being below the minimum SOC threshold (202); determine that a SOC decrease rate (225) is above the expected SOC decrease rate (203) by comparing measured SOC data (215) to previous measured SOC data (215); and determine that a SOC decrease rate (225) is above the expected SOC decrease rate (203) by obtaining a SOC data calibration event indicator (14c) from the energy source (14).

10. A battery pack (300), comprising one or more battery cells (310) and the computer system (100) of any one of claims 1 to 9 configured to obtain measured SOC data (215) of at least one of the one or more battery cells (310).

11. An energy management system (400), comprising one or more battery packs (300) and the computer system (100) of any one of claims 1 to 9 configured to obtain measured SOC data (215) of at least one of the one or more battery packs (300).

12. A vehicle (10) comprising one or more energy sources (14) and the computer system (100) of any one of claims 1 to 9 configured to obtain measured SOC data (215) of at least one of the one or more energy sources (14).

13. A computer implemented method (500) comprising:
obtaining (510), by processing circuitry (110) of a computer system (100), measured state of charge, SOC, data (215) of an energy source (14) of a vehicle (10),
determining (520), by processing circuitry (110) of the computer system (100), that a measured SOC decrease rate (225) is above an expected SOC decrease rate (203) by a predetermined SOC decrease rate threshold (203T);
determining (530), by processing circuitry (110) of the computer system (100), an SOC difference (235) based on the measured SOC data (215) and the expected SOC decrease rate (203);
determining (540), by processing circuitry (110) of the computer system (100), an SOC correction (245) based on the SOC difference (235);
reducing (550), by processing circuitry (110) of the computer system (100), an SOC buffer (255) of the energy source (14) by the SOC correction (245); and
providing (560), by processing circuitry (110) of the computer system (100), filtered SOC data (265) of the energy source (14) by increasing the measured SOC data (215) by the SOC correction (245).

14. A computer program product (600) comprising program code (810) for performing, when executed by processing circuitry (110), the computer implemented method (500) of claim 13.

15. A non-transitory computer-readable storage medium (700) comprising instructions (810), which when executed by processing circuitry (110), cause the processing circuitry (110) to perform the computer implemented method (500) of claim 13.
